Europäisches Patentamt

European Patent Office

Office européen des brevets

(19)

(11) Numéro de publication: **0 272 961**
**B1**

(12) **FASCICULE DE BREVET EUROPEEN**

(45) Date de publication du fascicule du brevet: **23.01.91**

(51) Int. Cl.⁵: **H 05 K 7/20, H 02 J 9/06**

(21) Numéro de dépôt: **87402661.0**

(22) Date de dépôt: **25.11.87**

(54) **Cellule de logement d'une pluralité de sous-ensembles électroniques d'une alimentation statique sans coupure.**

(30) Priorité: **16.12.86 FR 8617709**

(43) Date de publication de la demande:
**29.06.88 Bulletin 88/26**

(45) Mention de la délivrance du brevet:
**23.01.91 Bulletin 91/04**

(84) Etats contractants désignés:
**AT BE CH DE ES GB IT LI NL SE**

(56) Documents cités:
**EP-A-0 026 443**
**FR-A-2 577 102**
**US-A-2 394 060**

(73) Titulaire: **MERLIN GERIN**
**Rue Henri Tarze**
**F-38050 Grenoble Cédex (FR)**

(72) Inventeur: **Fiorina, Jean-Noel**
**Merlin Gerin Sce. Brevets**
**F-38050 Grenoble Cédex (FR)**
Inventeur: **Denis, Hervé**
**Merlin Gerin Sce. Brevets**
**F-38050 Grenoble Cédex (FR)**

(74) Mandataire: **Kern, Paul et al**
**Merlin Gerin Sce. Brevets 20, rue Henri Tarze**
**F-38050 Grenoble Cédex (FR)**

**ELECTRO AND MINI/MICRO NORTHEAST, New York, 23-25 avril 1985, pages 1-5, New York, US; P.R. BERKOWITZ et al.: "A distributed power architecture for the system 75 digital communications system"**
**IRE NATIONAL CONVENTION RECORD, vol. 7, tome 6, 23-26 mars 1959, pages 148-157; A. PERLMUTTER: "Uniform cooling air flow during computer maintenance and operation"**

Courier Press, Leamington Spa, England.

## Description

L'invention est relative à une cellule de logement d'une pluralité de sous-ensembles électroniques d'un système d'alimentation statique sans coupure ayant un redresseur chargeur CH dont l'entrée est raccordée à un réseau à courant alternatif, un onduleur M connecté à la sortie du redresseur chargeur pour la conversion continualternatif, et une batterie B d'accumulateurs disposée en tampon pour constituer un stock d'énergie disponible en permanence à l'entrée de l'onduleur M, la cellule comprenant un châssis métallique de forme parallélé pipédique, associé à des parois d'obturation parallèles deux à deux délimitant une face avant, une face arrière, et deux faces latérales opposées s'étendant dans le sens de la profondeur de la cellule, les sous-ensembles électroniques étant soumis à une circulation forcée d'air de refroidissement engendrée par un groupe de ventilation susceptible d'aspirer l'air frais par un orifice d'admission et de refouler l'air réchauffé vers l'extérieur par un orifice d'échappement.

L'intervention du groupe de ventilation à l'intérieur d'une cellule connue de l'art antérieur s'effectue localement au voisinage des radiateurs sur lesquels sont montés les composants électroniques de puissance. Le refroidissement des sous ensembles électroniques est bien assuré, mais des risques d'accumulation de chaleur subsistent dans certaines parties basses de la cellule où sont logés d'autres organes électriques et électroniques de l'alimentation statique. La mauvaise répartition interne de la chaleur limitent de ce fait les puissances électriques de telles installations.

L'objet de l'invention consiste à améliorer le refroidissement des alimentations statiques sans coupure.

La cellule selon l'invention est caractérisée en ce que les sous-ensembles électroniques sont formés par un regroupement de modules M1, M2, M3, CH, CS, enfichables, accessibles par une porte de la face avant et disposés au-dessus du groupe de ventilation comprenant au moins un ventilateur, l'ensemble modules et ventilateurs s'étendant sur une fraction de la profondeur de la cellule, de manière à ménager un compartiment arrière servant de logement à un transformateur de commande de l'onduleur M, et que le ventilateur comporte un orifice principal de refoulement dirigé vers la face avant et destiné à établir un premier trajet F1 interne d'air de refroidissement après mise en pression de l'air contenu dans l'espace antérieur situé entre les modules et la face avant, et un orifice secondaire de refoulement, disposé à l'opposé de l'orifice principal, pour engendrer un deuxième trajet interne d'air de refroidissement vers le transformateur, la dimension de l'orifice secondaire étant plus petite que celle de l'orifice principal.

Le ventilateur et le transformateur se trouvent en appui sur un support séparé du fond de la cellule par un vide à travers lequel est aspiré l'air par ledit orifice d'admission. Les deux trajets d'air de refroidissement sont indépendants l'un de l'autre en étant agencés en parallèle entre les orifices de refoulement et l'orifice d'échappement, ce dernier étant disposé au-dessus des modules et au voisinage du couvercle de la cellule.

La présence de ces deux trajets d'air de refroidissement permet d'uniformiser la température à l'intérieur de la cellule, et d'assurer un refroidissement efficace de tous les organes constitutifs de l'alimentation statique.

Selon une caractéristique de l'invention, la partie antérieure de chaque module comporte une grille de turbulence faisant saillie dans l'espace antérieur, de manière à coopérer avec l'écoulement ascendant de l'air en provenance de l'orifice principal de refoulement, et engendrer une circulation horizontale de l'air le long des modules, et dans le sens de la profondeur vers l'orifice d'échappement.

La grille de turbulence est avantageusement inclinée vers le bas.

D'autres avantages et caractéristiques ressortiront plus clairement de la description qui va suivre d'un mode de réalisation de l'invention, donné à titre d'exemple non limitatif et représenté aux dessins annexés, dans lesquels:

la figure 1 représente le schéma électrique unifilaire d'un système d'alimentation sans coupure;

la figure 2 est une vue schématique en élévation de la cellule après enlèvement de la face avant;

la figure 3 montre une vue en coupe selon la ligne III—III de la figure 2;

la figure 4 est une vue en perspective du socle fixe de raccordement associé à un tiroir mobile embrochable;

les figures 5 à 8 montrent les vues en perspective des opérations successives de réalisation d'un tiroir embrochable;

la figure 9 est une vue éclatée en perspective d'un tiroir complètement équipé;

les figures 10A, 10B, 10C, représentent les vues en élévation de la face arrière d'une plaque de connexion d'un tiroir, respectivement pour un module mutateur d'un onduleur, pour un module redresseur chargeur, et pour un module normal secours à contacteur statique;

les figures 11 et 12 montrent deux montages possibles des composants électroniques de puissance sur la semelle radiateur d'un tiroir;

la figure 13 représente une vue en perspective d'un élément constitutif du socle de raccordement;

la figure 14 montre une vue en perspective d'une plaque non équipée du socle de raccordement;

la figure 15 représente une vue partielle en perspective à échelle agrandie de l'arrière d'un tiroir lors de l'embrochage dans le socle de raccordement;

la figure 16 représente une variante de la cellule selon la fig. 2.

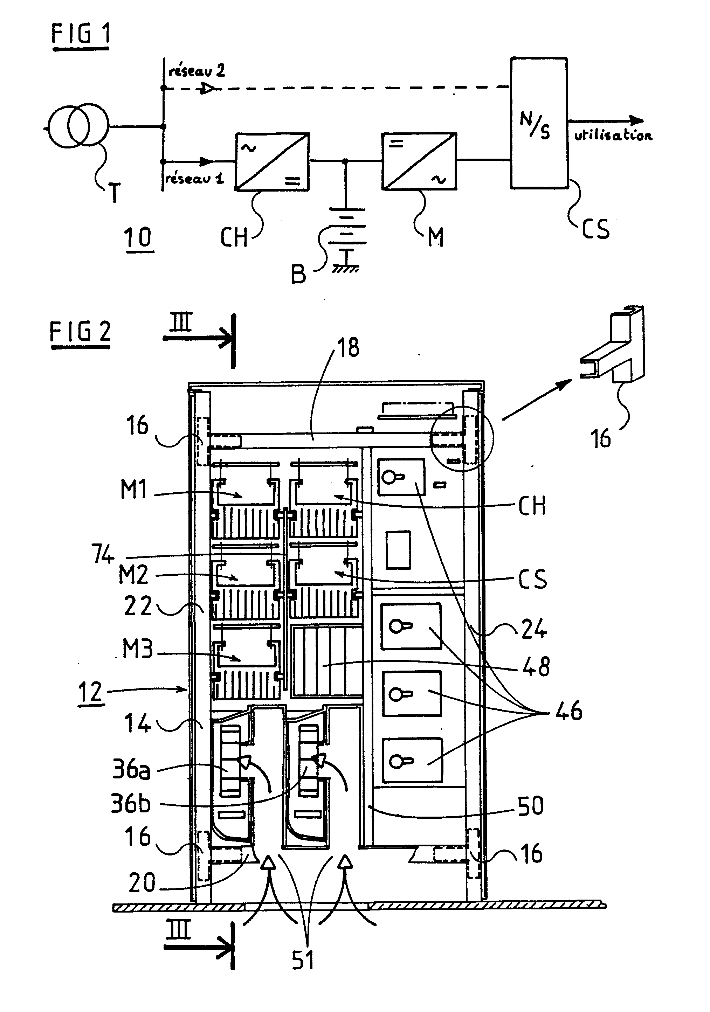

La figure 1 montre le schéma électrique unifilaire d'un système d'alimentation statique 10 sans coupure, comportant un redresseur chargeur CH, raccordé à un premier réseau 1, un onduleur M pour la conversion continu/alternatif et une batterie B d'accumulateurs disposée en tampon. La batterie B constitue un stock d'énergie disponible en permanence aux bornes d'entrées de l'onduleur M. Un dispositif inverseur normal secours N/S disposé entre l'onduleur M et l'utilisation est équipé d'un contacteur statique CS pour assurer le passage automatique et sans coupure du premier réseau 1 à un deuxième réseau 2. Le fonctionnement d'une telle alimentation est bien connu, et il suffit de rappeler qu'en présence de la tension sur le premier réseau 1, l'énergie est fournie à l'utilisation à travers le redresseur-chargeur CH et l'onduleur M. La batterie B est maintenue en permanence en état de charge par le redresseur chargeur CH qui assure la conversion alternatif continu. A la disparition de la tension sur le premier réseau 1, l'alimentation de l'onduleur M est transféré instantanément et sans aucune perturbation pour l'utilisation du redresseur-chargeur CH vers la batterie B.

La batterie B fournit l'énergie nécessaire à l'onduleur M dans les limites de son autonomie. Après retour de la tension sur le premier réseau 1, le redresseur-chargeur CH alimente à nouveau l'onduleur M, et assure la recharge de la batterie B.

En cas de surcharge du côté utilisation ou de défaut d'alimentation, le récepteur de l'utilisation est immédiatement connecté au deuxième réseau 2 par l'inverseur N/S à contacteur statique CS, et ne subit aucune perturbation. Le retour sur l'onduleur M s'opère automatiquement en fin de surcharge.

Les deux réseaux 1 et 2 du système d'alimentation 10 statique peuvent être raccordés à un transformateur T monophasé ou triphasé d'un tableau général à basse tension, dont l'appareillage de protection n'a pas été représenté.

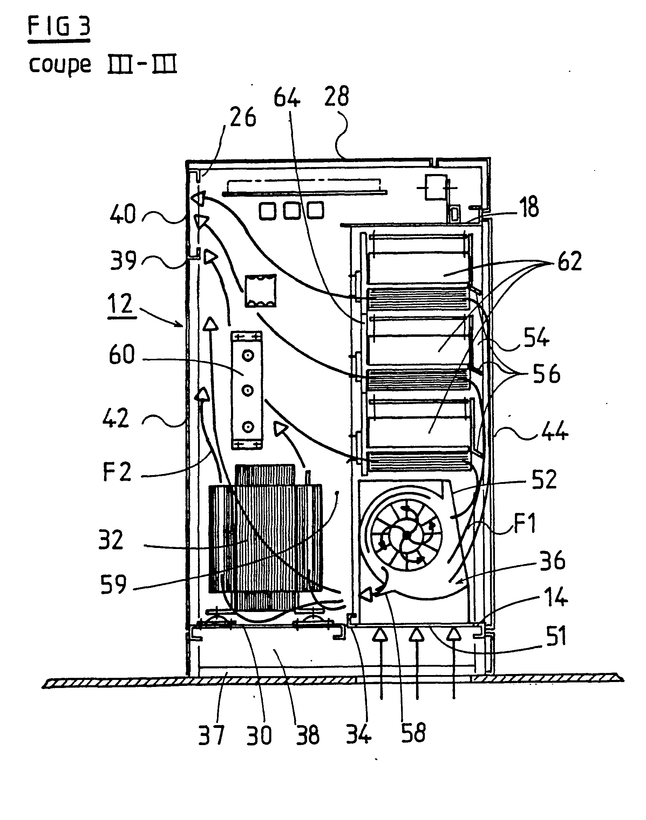

Le système d'alimentation statique 10 est logé dans une cellule 12 (figures 2 et 3) ayant un châssis 14 métallique en forme de parallélépipède droit. L'ossature antérieure au châssis 14 comporte quatre équerres 16 d'assemblage en forme de T, susceptibles de s'emboîter à chaque angle, dans des traverses supérieure 18 et inférieure 20, et dans des flasques 22, 24, verticaux opposées, parallèles deux à deux. L'ossature postérieure du châssis 14 comprend une traverse supérieure 26 servant de support au couvercle 28, et une plaque 30 horizontale de support d'un transformateur 32 associé à la commande de l'onduleur M. La traverse inférieure 20 fait partie d'une plaque 34 horizontale de support d'un groupe de ventilation 36. Les deux plaques 30, 34, sont coplanaires et sont séparées verticalement du fond 37 de la cellule 12 par un vide 38.

La traverse supérieure 26 de l'ossature postérieure comprend un orifice 39 d'échappement équipé d'une grille 40 de ventilation faisant communiquer le volume supérieur de la cellule 12 avec le milieu extérieur. Un panneau 42 arrière relie la traverse 26 supérieure à la plaque 30 inférieure, et s'étend parallèlement à la face avant 44 de la cellule 12.

La face avant 44 est pourvue à gauche d'une première porte d'accès aux différents sous-ensembles électroniques du système d'alimentation statique 10 comprenant les modules mutateurs M1, M2, M3 de l'onduleur M, le module redresseur-chargeur CH, et le module inverseur normal secours à contacteur statique CS, et à droite une deuxième porte pour l'accès à l'appareillage électrique 46 de protection et d'isolement, comportant des sectionneurs, interrupteurs ou disjoncteurs Un panier 48 à cartes électroniques de surveillance et de commande est disposé sous le module à contacteur statique CS et à côté du mutateur inférieur M3 associé à l'une des phases de l'onduleur M.

Un cadre 50 vertical intermédiaire (figure 2) sépare les différents sous-ensembles électroniques de l'appareillage électrique 46. Chaque porte à axe vertical est supporté par deux charnières (non représentées) en castrées dans les deux équerres 16 d'assemblage disposées d'un même côté de l'ossature antérieure du châssis 14.

Le groupe de ventilation 36 est agencé dans le volume inférieur de la cellule 12 du côté de la porte de gauche et comporte une paire de ventilateurs 36a, 36b, disposés côte à côte sur la plaque 34. L'air de ventilation des deux ventilateurs 36a, 36b est aspiré latéralement à travers un orifice d'admission 51 de l'espace aval du vide 38, et est refoulé vers l'orifice 39 d'échappement selon deux trajets internes de refroidissement, indiqués par les flèches F1 et F2 (figure 3). Le premier trajet F1 provient de l'orifice principal 52 de refoulement des ventilateurs 36a, 36b, et assure la mise en pression de l'espace antérieur 54 de la cellule 12 situé entre les sous-ensembles électroniques et la face avant 44. Il en résulte une circulation forcée horizontale de l'air dans le sens de la profondeur de la cellule, de manière à refroidir efficacement les différents modules M1, M2, M3, CH et CS constitutifs des sous-ensembles électroniques, ainsi que le panier 48 à cartes. La circulation horizontale de l'air est favorisée par la présence de grilles 56 de turbulence, fixées à la partie antérieure des modules. Chaque grille 56 est légèrement inclinée vers le bas, et fait saillie dans l'espace 54 pour intercepter l'écoulement ascendant de l'air en provenance de l'orifice principal 52 de refoulement.

Le deuxième trajet F2 de l'air est engendré par un orifice de refoulement secondaire 58 des ventilateurs 36a, 36b, dirigé vers le transformateur 32 de l'onduleur M, situé dans le compartiment arrière 59 inférieur de la cellule 12. L'orifice secondaire 58 est plus petit que l'orifice principal 52 de refoulement et les deux trajets F1, F2 d'air de refroidissement sont indépendants l'un de l'autre en étant agencés en parallèle entre les orifices de refoulement 52, 58 des ventilateurs 36a, 36b, et l'orifice d'échappement 39 de la cellule 12.

L'air de ventilation du deuxième trajet F2 assure en plus du refroidissement du transformateur 32, celui d'autres composants du système d'alimentation 10, notamment des condensateurs 60 de filtrage ménagés dans la zone médiane de la cellule 12 entre l'orifice d'échappement 39 et le transformateur 32.

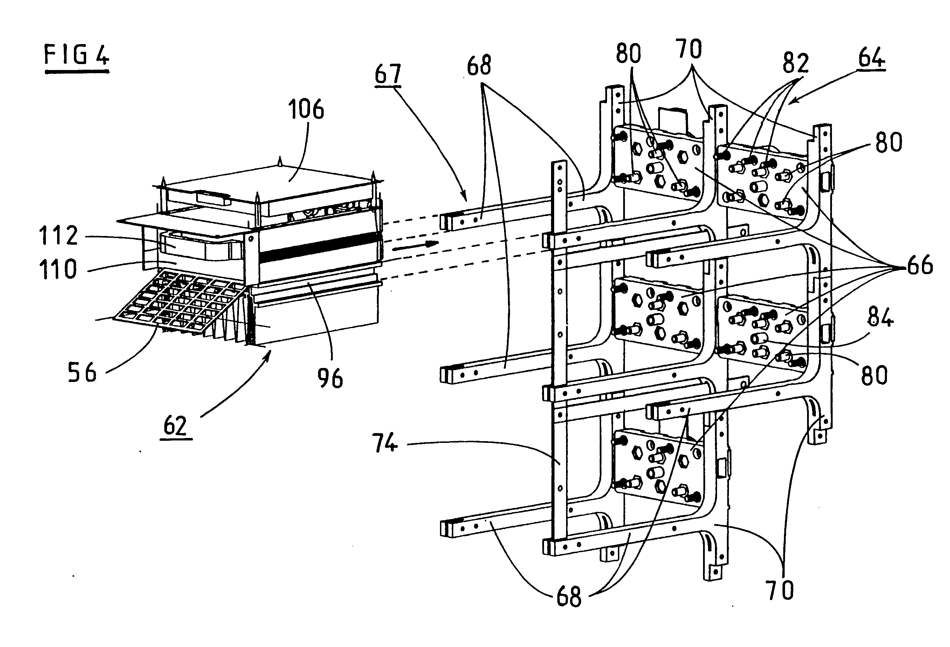

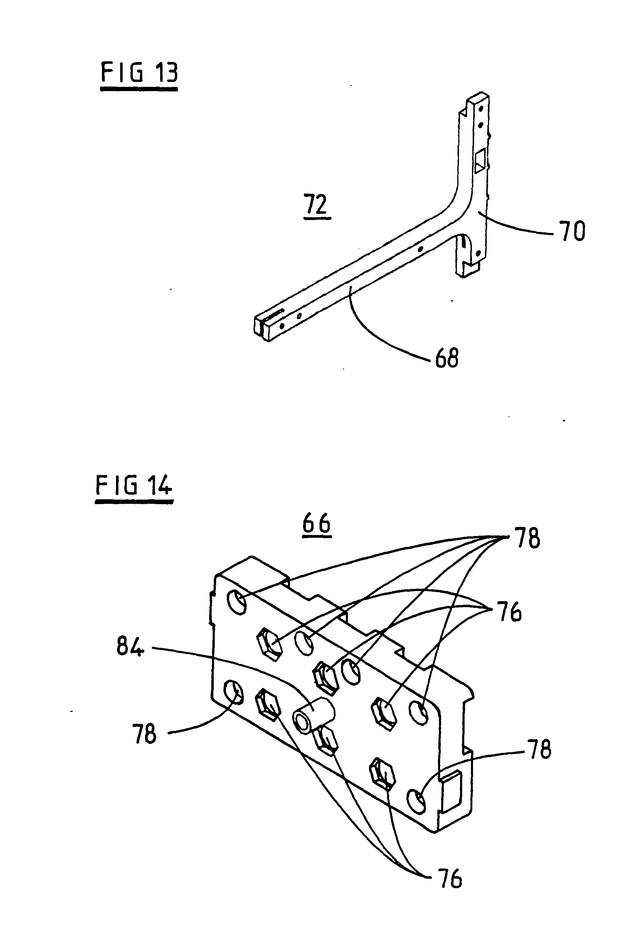

Les différents modules M1, M2, M3 de l'onduleur M, du redresseur-chargeur CH, et de l'inverseur normal secours à contacteur statique CS sont constitués par une pluralité de tiroirs 62 élémentaires juxtaposés, coopérant par embrochage avec un socle 64 fixe de raccordement (voir figures 3 et 4) . Le socle 64 comporte une série de plaques supports 66 d'embrochage, en nombre égal à celui des tiroirs 62, et un dispositif de guidage 67 en translation des tiroirs 62 mobiles lors de la course d'embrochage. Le dispositif de guidage 67 est équipé de plusieurs glissières 68 parallèles en forme de bras rectilignes s'étendant vers la face avant 24 de la cellule 12 selon une direction perpendiculaire au plan de logement des plaques supports 66 d'embrochage. Les glissières 68 sont portées par des consoles 70 emboîtables entre lesquelles sont insérées les différentes plaques supports 66 d'embrochage. Une glissière 68 et la console 70 correspondante sont formées avantageusement par une pièce 72 unique standard en forme de T et en matériau isolant moulé, représentée en détail sur la figure 13. L'assemblage modulaire préliminaire par emboîtement des différentes pièces 72 et des plaques supports 66 d'embrochage permet d'obtenir facilement une extension du socle 64 de raccordement en fonction du nombre de tiroirs 62 embrochables du système d'alimentation statique 10. L'assemblage définitif du socle 64 modulaire s'opère ensuite par une opération de rivetage des différentes consoles 70.

Les extrémites anterieures des glissieres 68 superposées logées dans le plan intermédiaire vertical du socle 64 de raccordement, sont reliées entre elles par un conducteur de masse 74 (figures 2 et 4), susceptible d'interconnecter les radiateurs de refroidissement des différents sous-ensembles électroniques, en position embrochée des tiroirs 62. Ce conducteur de masse 74 fait partie d'un plan de masse interne, ayant fait l'objet d'une demande de brevet français N° 86 1 5620 déposée le 5/11/1986 par la demanderesse.

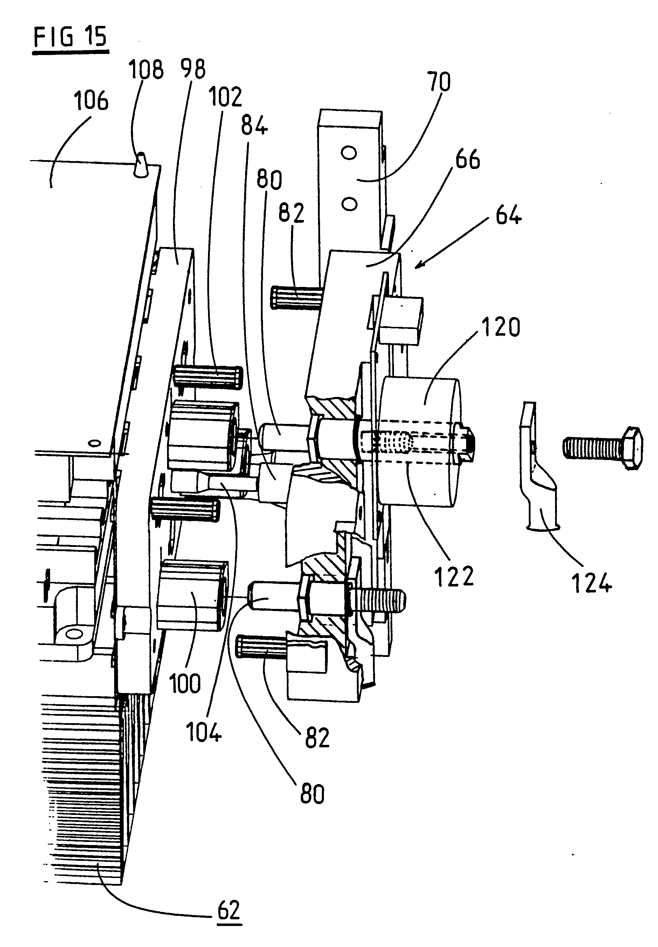

Chaque plaque support 66 élémentaire du socle 64 de raccordement présente une structure rectangulaire en matériau isolant (voir figure 14), ayant six trous 76 hexagonaux réparties en deux séries superposées de trois trous, et six orifices 78 circulaires, dont quatre le long de l'arête supérieure, et deux aux angles inférieurs de la plaque 66. Les trous 76 sont destinés à recevoir des broches ou plots (80, figure 4) en matériau conducteur, tandis que les orifices 78 peuvent être obturés par des moyens de détrompage 82 en forme de tenons ou pions faisant saillie de la surface plane de la plaque support 66. La zone centrale de chaque plaque support 66 comporte de plus une douille 84 de centrage du tiroir 62 mobile.

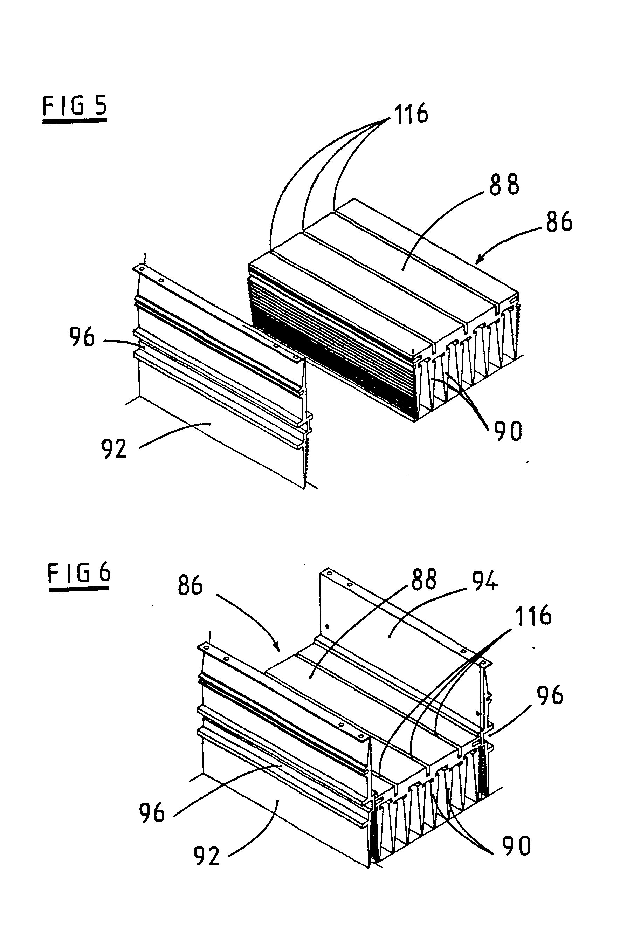

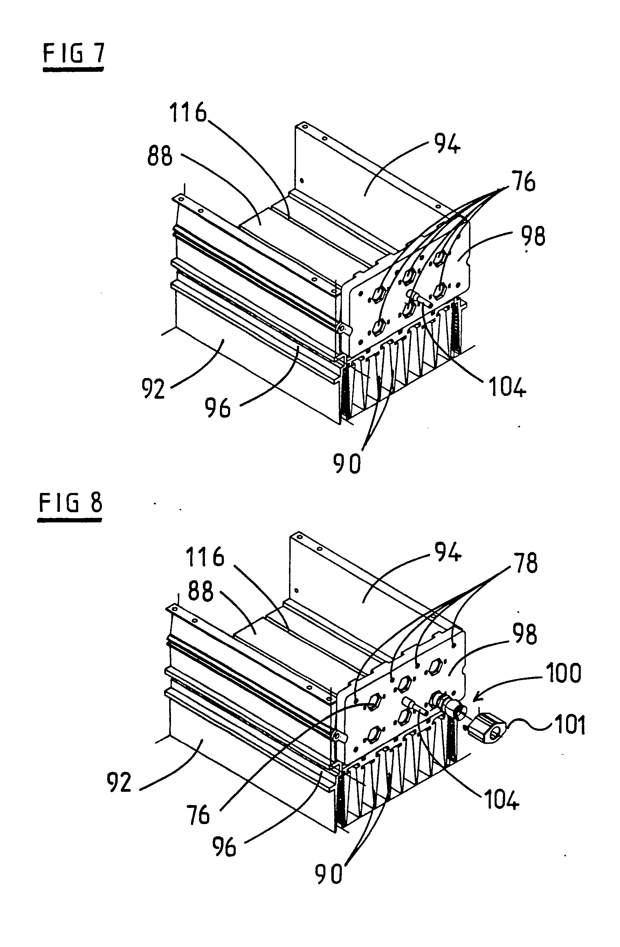

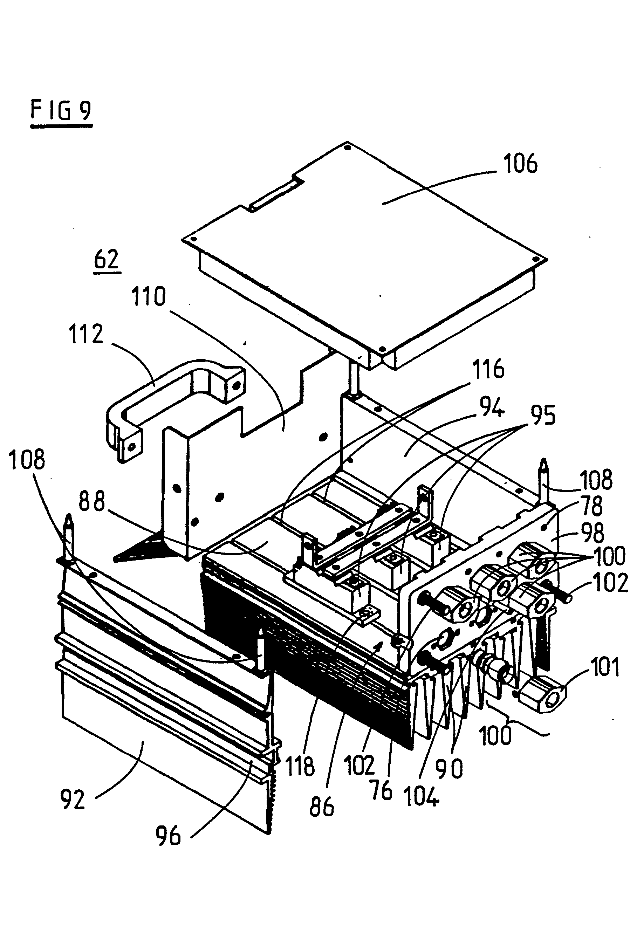

L'architecture d'un tiroir 62 embrochable est représentée aux figures 5 à 9. Chaque tiroir 62 comporte un bloc de base 86 en matériau métallique bon conducteur de la chaleur, ayant une semelle radiateur 88 à ailettes 90 de refroidissement, et deux flasques 92, 94, latéraux fixés verticalement sur les bords opposés de la semelle 88. La face supérieure de la semelle 88 radiateur est plane, et sert de support pour les composants électroniques 95 de puissance notamment des transistors ou des thyristors. Les ailettes 90 de refroidissement sont échelonnées le long de la face inférieure de la semelle 88, et s'étendant vers le bas, selon une direction parallèle aux flasques 92, 94. La surface extérieure de chaque flasque 92, 94 du tiroir 62 est équipée d'une rainure 96 longitudinale de positionnement destinée à coopérer, lors de l'embrochage avec la glissière 68 correspondante du socle 64 de raccordement.

La face arrière de chaque tiroir 62 est pourvue d'une plaque 98 à contacts 100 du type tulipe; la structure de la plaque 98 est similaire à celle des plaques supports 66 (figure 14) du socle 64 fixe, et comporte six trous 76 hexagonaux pour la réception des contacts 100 à tulipe, et six orifices 78 pour la réception de moyens de détrompage 102. La zone centrale de la plaque 98 à contacts 100 comprend de plus une pièce 104 mâle de positionnement susceptible de s'engager dans la douille 84 de centrage de la plaque 66 conjuguée lors de l'embrochage des contacts 100 à tulipe dans les plots 80 correspondants du socle 64 de raccordement. Les contacts 100 à tulipe sont connectés aux composants électroniques semi-conducteurs 95 par des éléments de liaison (non représentés) se trouvant à l'intérieur du tiroir 62 au-dessus de la semelle 88.

Une carte 106 électronique de commande des organes semi-conducteurs 95 sert de couvercle au tiroir 62 en reposant sur les flasques 92, 94 latéraux par l'intermédiaire de quatre entretoises 108. La face avant du tiroir 62 comporte une platine 110 à laquelle sont fixées la grille 56 de turbulence de l'air de ventilation, et une poignée 112 d'actionnement en translation du tiroir 62 embrochable. Chaque contact 100 à tulipe est protégé par un cache tulipe 101.

Les contacts 100 à tulipe de la plaque 98 des tiroirs 62 peuvent bien entendu être remplacés par des pinces d'embrochage.

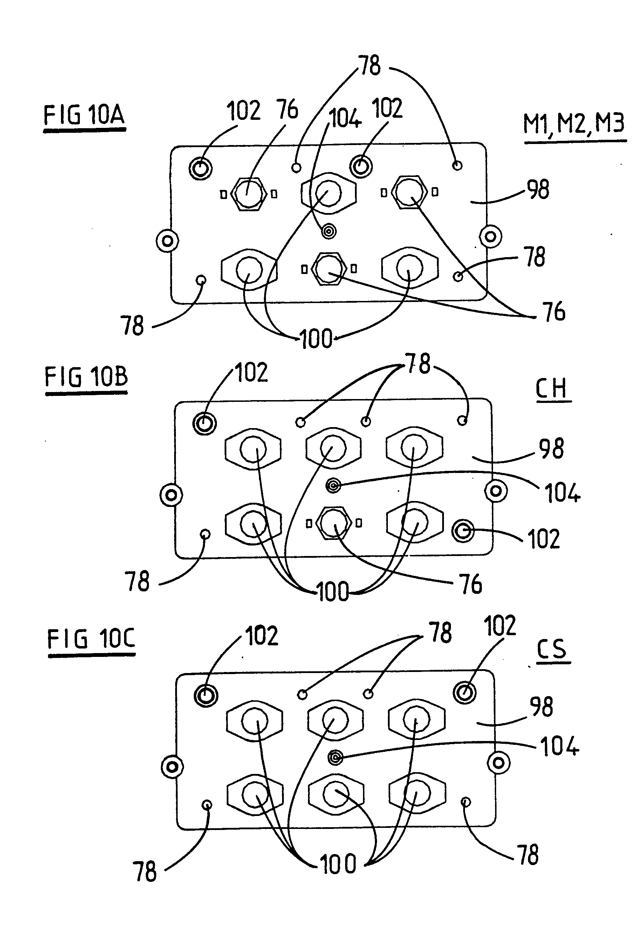

La répartition uniforme des trous 76 et orifices 78 sur les plaques 66, 98, respectives du socle 64 et des tiroirs 62 permet d'établir un codage précis de raccordement selon le type et la puissance des modules constitutifs du système d'alimentation statique 10. Les figures 10A, 10B et 10C montrent la configuration de la plaque 98 équipée du système de raccordement et de détrompage d'un tiroir 62 mobile pour chaque type de module, susceptible de coopérer avec le socle 64 fixe de raccordement de la figure 4. Sur la figure 10A relative à un module mutateur M1, M2, M3 d'une phase d'un onduleur M, les trois contacts 100 à tulipe de la plaque 98 peuvent s'engager dans les broches 80 conjuguées de l'une quelconque des trois plaques 66 superposés situées dans la colonne de gauche du socle 64 (figure 4). Les deux moyens de détrompage 102 de la plaque 98 peuvent s'introduire dans les orifices 78 restés libres dans les plaques 66 précitées, et réciproquement les quatre moyens de détrompage 82 des plaques 66 peuvent s'engager dans les quatre orifices 78 restés libres dans la plaque 98.

Sur la figure 10B relative à un module redresseur chargeur CH, les cinq contacts 100 à tulipe de la plaque 98 peuvent s'embrocher dans les cinq broches 80 correspondantes de la plaque 66 située en haut à droite sur le socle 64 de la figure 4.

Sur la figure 10C relative à un module inverseur normal-secours à contacteur statique CS, les six contacts 100 à tulipe de la plaque 98 peuvent s'embrocher dans les six broches 80 correspondantes de la plaque 66 située en bas à droite sur le socle 64 de la figure 4. La coopération réciproque des moyens de détrompage 82, 102, sur les deux plaques 66, 98, évite toute erreur de branchement lors du montage des différents sous-ensembles de la cellule 12, (voir figure 15). Les moyens de détrompage 82, 102, sont formés par des pions.

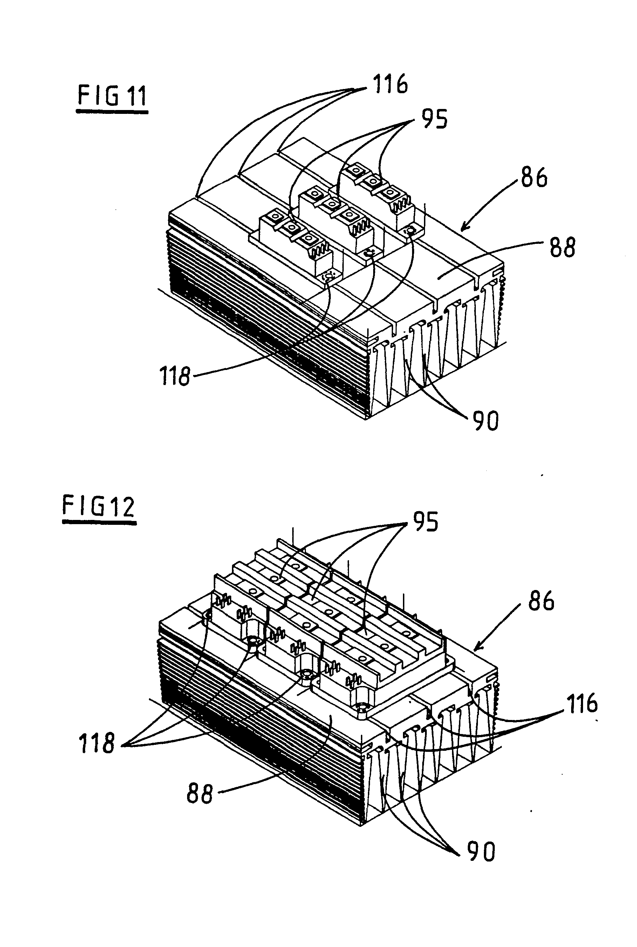

La face supérieure de la semelle 88 radiateur de chaque bloc de base 86 est munie de plusieurs rainures 116 longitudinales s'étendant parallèlement selon la direction des flasques 92, 94. La fixation des composants électroniques 95 de puissance sur la semelle 88 s'effectue au moyen de vis 118 autotaraudeuses pouvant s'engager dans les rainures 116 dans n'importe quelle position. Les composants 95 peuvent être agencés longitudinalement (figure 11) ou transversalement (figure 12) sur la semelle 88. Cette configuration à rainures 116 permet de standardiser le bloc de base 86 pour tous les types de modules, et évite toutes opérations de perçage de trous spécifiques, et de surfaçage supplémentaire pour l'enlèvement des bavures de perçage. Les rainures 116 sont réalisées automatiquement lors de la fabrication de la semelle 88 à base d'alliage d'aluminium.

Des capteurs de courant 120 (figure 15) peuvent équiper certains modules en étant fixés sur la face arrière du socle 64 de raccordement, à l'opposé des pions de détrompage 82. La connexion électrique des capteurs 120 s'opère au moyen de traversées 122 conductrices pouvant s'adapter sur des broches 80 conductrices de la plaque 66. Les capteurs de courant peuvent être constitués par des transformateurs d'intensité ou des cellules à effet Hall. Un départ 124 peut être fixé à l'extrémité postérieure de chaque traversée 122.

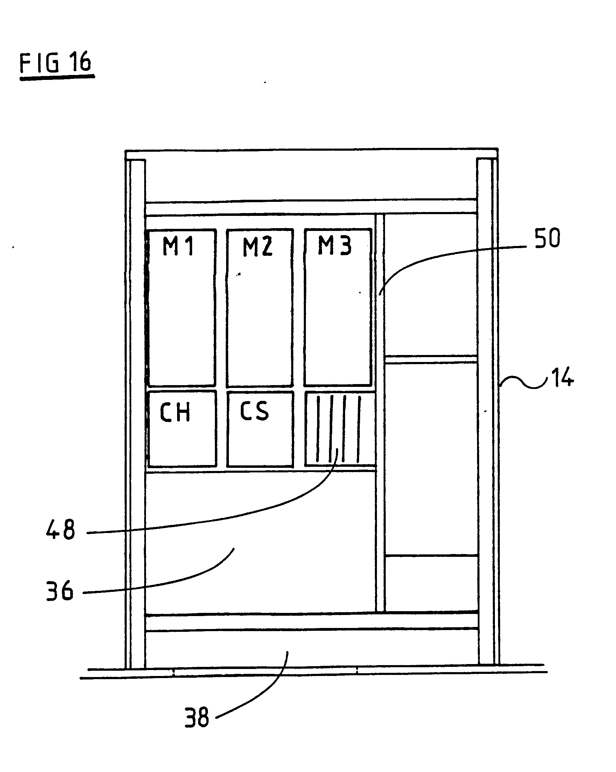

La répartition des différents modules M1, M2, M3, CH, CS sur le socle 64 de raccordement peut bien entendu être modifiée en fonction du type et de la puissance du système d'alimentation 10. La figure 16 montre une telle variante dans laquelle les trois modules mutateurs M1, M2 et M3 de l'onduleur M sont disposés respectivement au-dessus du module redresseur-chargeur CH, du module à contacteur statique CS, et du panier 48 à cartes électroniques.

## Revendications

1. Cellule de logement d'une pluralité de sous-ensembles électroniques d'un système d'alimentation statique sans coupure ayant un redresseur-chargeur CH dont l'entrée est raccordée à un réseau à courant alternatif, un onduleur M connecté à la sortie du redresseur-chargeur CH pour la conversion continualternatif, et une batterie B d'accumulateurs disposée en tampon pour constituer un stock d'énergie disponible en permanence à l'entrée de l'onduleur M, la cellule (12) comprenant un châssis (14) métallique de forme parallélépipédique, associé à des parois d'obturation parallèles deux à deux délimitant une face avant, une face arrière, et deux faces latérales opposées s'étendant dans le sens de la profondeur de la cellule, les sous-ensembles électroniques étant soumis à une circulation forcée d'air de refroidissement engendrée par un groupe de ventilation (36) susceptible d'aspirer l'air frais par un orifice d'admission (51) et de refouler l'air réchauffé vers l'extérieur par un orifice d'échappement (39), caractérisée en ce que les sous-ensembles électroniques sont formés par un regroupement de modules M1, M2, M3, CH, CS enfichables, accessibles par une porte de la face avant et disposés au-dessus du groupe de ventilation (36) comprenant au moins un ventilateur (36a, 36b), l'ensemble modules et ventilateurs s'étendant sur une fraction de la profondeur de la cellule (12), de manière à ménager un compartiment arrière (59) servant de logement à un transformateur (32) de commande de l'onduleur M, et que le ventilateur (36a, 36b) comporte un orifice principal (52) de refoulement dirigé vers la face avant et destiné à établir un premier trajet F1 interne d'air de refroidissement après mise en pression de l'air contenu dans l'espace antérieur (54) situé entre les modules et la face avant (44), et un orifice secondaire (58) de refoulement, disposé à l'opposé de l'orifice principal (52), pour engendrer un deuxième trajet F2 interne d'air de refroidissement vers le transformateur (32), la dimension de l'orifice secondaire (58) étant plus petite que celle de l'orifice principal (52).

2. Cellule selon la revendication 1, caractérisé en ce que le ventilateur (36a, 36b) et le transformateur (32) se trouvent en appui sur un support (30 séparé du fond (37) de la cellule (12) par unvide (38) à travers lequel est aspiré l'air par ledit orifice d'admission (51), et que les deux trajets F1, F2 d'air de refroidissement sont indépendants l'un de l'autre en étant agencés en parallèle entre les orifices de refoulement (52, 58), et l'orifice d'échappement (39), ce dernier étant disposé au-dessus des modules, et au voisinage du couvercle (28) de la cellule (12).

3. Cellule selon la revendication 2 caractérisé en ce que l'orifice d'échappement (39) est situé dans la face arrière de la cellule (12), et est équipé d'une grille de ventilation (40) faisant communiquer le volume supérieur de la cellule (12) avec le milieu extérieur.

4. Cellule selon l'une des revendications 1 à 3, caractérisé en ce que la partie antérieure de chaque module M1, M2, M3, CH, CS, comporte une grille de turbulence (56) faisant saillie dans l'espace antérieur (54), de manière à coopérer avec l'écoulement ascendant de l'air en provenance de l'orifice principal (52) de refoulement, et engendrer une circulation horizontale de l'air le long des modules, et dans le sens de la profondeur vers l'orifice d'échappement (39) .

5. Cellule selon la revendication 4, caractérisé en ce que la grille de turbulence (56) de chaque module est légèrement inclinée vers le bas.

6. Cellule selon l'une des revendication 1 à 5, caractérisé en ce que l'ossature antérieure du châssis (14) comporte quatre équerres (16) d'assemblage en forme de T, susceptibles de s'emboîter à chaque angle dans des traverses supérieure (18) et inférieure (20), et dans des flasques (22, 24) verticaux opposés, et que la porte d'accès aux modules est supportée par deux charnières encastrées dans deux équerres (16) d'assemblage disposées verticalement d'un même côté du châssis (14) .

7. Cellule selon l'une des revendications 1 à 6, caractérisé en ce que le châssis (14) est équipé d'un système de séparation interne à cadre (50) vertical, destiné à subdiviser le volume interne de la cellule (12) en un premier compartiment antérieur de logement des modules et du groupe de ventilation (36), un compartiment arrière (59) de logement du transformateur (32), et un deuxième compartiment antérieur de logement de l'appareillage électrique (46) de protection et d'isolement du système d'alimentation statique.

**Patentansprüche**

1. Schrank zur Unterbringung von mehreren elektronischen Untergruppen für ein statisches unterbrechungsfreies Stromversorgungssystem mit einem Lade-Gleichrichter CH, dessen Eingang mit einem Wechselstromnetz verbunden ist, wobei ein Wechselrichter M mit dem Ausgang des Lade-Gleichrichters CH verbunden ist für die Umwandlung Gleichstrom-Wechselstrom, und eine als Dämpfer angeordnete Akkumulatorenbatterie, um eine am Eingang des Wechselrichters M fortdauernd zur Verfügung stehende Energiereserve zu bilden, wobei der Schrank (12) einen metallischen parallelipiped förmigen Rahmen (14) aufweist, der mit Verschlusswänden verbunden ist, die jeweils zu zweit parallel liegen und eine Vorderseite, eine Hinterseite und zwei gegenüberliegende Seitenflächen, die sich in Richtung der Schranktiefe erstrecken, aufweisen, wobei die elektronischen Untergruppen einem erzwungenen Kühlluftumlauf ausgesetzt sind, der von einer Belüftungsgruppe (36) erzeugt wird, welche Frischluft durch eine Einlassöffnung (51) ansaugen kann, und welche die erwärmte Luft durch eine Austrittsöffnung (39) nach aussen drückt, dadurch gekennzeichnet, dass die elektronischen Untergruppen von einer Gruppierung der einsteckbaren Module M1, M2, M3, CH, CS gebildet werden, die von einer Tür auf der Vorderseite zugänglich sind und über der Belüftungsgruppe (36) angeordnet sind, die mindestens einen Ventilator (36a, 36b) aufweist, wobei sich das Ganze, Module und Ventilatoren, auf einem Bruchteil der Tiefe des Schrankes (12) erstreckt, so um ein hinteres Abteil (59) zu bilden, das für die Unterbringung eines Steuertransformators (32) des Wechselrichters M dient, und dass der Ventilator (36a, 36b) eine Hauptöffnung (52) aufweist zum Verdrängen zur Vorderseite hin, und die dazu bestimmt ist, eine erste interne Kühlluftstrecke F1 herzustellen, nach dem die in dem zwischen den Modulen und der Vorderseite (44) gelegenen vorderen Raum (54) enthaltene Luft unter Druck gesetzt wurde, und eine Neben-Verdrängungsöffnung (58) aufweist, um eine zweite interne Kühlluftstrecke F2 zum Transformator (32) hin zu schaffen, wobei die Grösse der Nebenöffnung (58) kleiner ist als die der Hauptöffnung (52).

2. Schrank gemäss Anspruch 1, dadurch gekennzeichnet, dass der Ventilator (36a, 36b) und der Transformator (32) sich auf den Träger (30) stützen, der von der Hinterwand (37) des Schranks (12) durch einen Leerraum (38) getrennt wird, durch den die Luft von der genannten Einlassöffnung (51) angesaugt wird, und dass die beiden Kühlluftstrecken F1, F2 unabhängig voneinander sind und parallel zwischen den Verdrängungsöffnungen (52, 58) und der Ausströmöffnung (39) angeordnet sind, wobei die letztere über den Modulen und in der Nähe des Deckels (28) des Schrankes (12) angeordnet ist.

3. Schrank gemäss Anspruch 2, dadurch gekennzeichnet, dass die Ausströmöffnung (39) in der hinteren Wand des Schrankes (12) gelegen ist und mit einem Ventilationsgitter (40) ausgerüstet ist, das den oberen Raum des Schrankes (12) mit der Aussenatmosphäre verbindet.

4. Schrank gemäss einem der Ansprüche 1 bis 3, dadurch gekennzeichnet, dass der vordere Teil jedes Moduls M1, M2, M3, CH, CS ein Turbulenzgitteraufweist, das in den Vorderraum (54) hineinragt, so um mit der aus der Hauptverdrängungsöffnung (52) nach oben strömenden Luft zusammenzuarbeiten und einen waagerechten Luftumlauf entlang der Module zu erzeugen und in Richtung der Tiefe zur Ausströmungsöffnung (39) hin.

5. Schrank gemäss Anspruch 4, dadurch gekennzeichnet, dass das Turbulenzgitter (56) jedes Moduls leicht nach unten geneigt ist.

6. Schrank gemäss einem der Ansprüche 1 bis 5, dadurch gekennzeichnet, dass das vordere Gerüst des Rahmens (14) vier T-förmige Verbindungswinkel (16) aufweist, die sich in jedem Winkel in eine obere (18) und untere (20) Traverse einfügen können und in gegenüberliegende senkrechte Flansche (22, 24), und dass die Zugangstür zu den Modulen von zwei Scharnieren gehalten wird, die in zwei Verbindungswinkel (16) eingefügt sind, welche senkrecht auf derselben Seite des Rahmens (14) angeordnet sind.

7. Schrank gemäss einem der Ansprüche 1 bis 6, dadurch gekennzeichnet, dass der Rahmen (14) mit einem internen Trennsystem ausgerüstet ist, mit einer senkrechten Fassung (50), die dazu bestimmt ist, den Innenraum des Schrankes (12) zu unterteilen, in ein erstes vorderes Abteil zum Unterbringen der Module und der Belüftungsgruppe (36), in ein hinteres Abteil (59) zum Unterbringen des Transformators (32), und in ein zweites vorderes Abteil zum Unterbringen der elektrischen Geräte (46) zum Schutz und zur Isolierung des statischen Stromversorgungssystems.

## Claims

1. Housing cubicle for a plurality of electronic subracks for a static non-interrupted power supply system, comprising a rectifier-charger CH whose input is connected to an AC mains system, an inverter M connected to the rectifier-charger CH output for DC/AC conversion, and a battery bank B arranged as a buffer to constitute a permanently available power store at the inverter M input, the cubicle (12) comprising a metal frame (14) of parallelepipedic form, associated with blanking walls parallel two by two delimiting a front panel, a rear panel, and two opposite side panels extending depthwise in the cubicle, the electronic subracks being submitted to a forced circulation of cooling air generated by a ventilation unit (36) designed to suck fresh air into the cubicle through an inlet orifice (51) and to discharge the heated air to the outside, through an outlet orifice (39), characterized in that the electronic subracks are constituted by assembling the draw-in modules M1, M2, M3, CH, CS accessible via a door of the front panel and located above the ventilation unit (36) comprising at least one fan (36a, 36b), the modules and fans assembly extending over a fraction of the depth of the cubicle (12), in such a way as to arrange a rear compartment (59) acting as housing for a transformer (32) controlling the inverter M, and that the fan (36a, 36b) comprises a main discharge orifice (52) directed towards the front panel and designed to establish a first internal cooling air path (F1) after pressurization of the air contained in the front space (54) situated between the modules and the front panel (44), and a secondary discharge orifice (58) located opposite the main orifice (52), to generate a second internal cooling air path (F2) towards the transformer (32), the dimension of the secondary orifice (58) being smaller than that of the main orifice (52).

2. Cubicle according to claim 1, characterized in that the fan (36a, 36b) and the transformer (32) are supported by a support (30) separated from the bottom (37) of the cubicle (12) by a space (38) through which is sucked air by said inlet orifice (51), and that the two cooling air paths (F1, F2) are independent from one another and arranged in parallel between the discharge orifices (52, 58) and the cubicle outlet orifice (39), the latter being located above the modules and in proximity to the cover (28) of the cubicle (12).

3. Cubicle according to claim 2, characterized in that the outlet orifice (39) is located in the rear panel of the cubicle (12) and is provided with a ventilation grate (40) making communicate the upper volume of the cubicle (12) with the ambient air.

4. Cubicle according to one of the claims 1 to 3, characterized in that the front part of each module M1, M2, M3, CH, CS, comprises a turbulence grate (56) protruding into the rear space (54), in such a way as to cooperate with the outlet of the rising air coming from the main discharge orifice (52), and to generate a horizontal air circulation along the modules, and depthwise towards the outlet orifice (39).

5. Cubicle according to claim 4, characterized in that the turbulence grate (56) of each module is slightly inclined to the bottom.

6. Cubicle according to one of claims 1 to 5, characterized in that the front part of the frame (14) comprises four T-shaped assembly brackets (16), capable of clipping at each corner into upper (18) and lower (20) cross-members, and into opposing vertical flanges (22, 24), and that the access door to the modules is supported by two hinges flush-mounted in two assembly brackets (16) vertically arranged on the same side of the frame (14).

7. Cubicle according to one of claims 1 to 6, characterized in that the frame (14) is provided with an internal separation system with a vertical frame (50), designed to subdivide the internal volume of cubicle (12) into a first front compartment for housing the modules and the fan unit (36), a rear compartment (59) for housing the transformer (32) and a second front compartment for housing the electrical switch gear (46) for the protection and isolation of the static power supply system.

<u>FIG 1</u>

<u>FIG 2</u>

# FIG 3
## coupe III-III

FIG 4

EP 0 272 961 B1

FIG 5

116

88

86

96

92

90

FIG 6

86

88 94

116

96

96

92

90

## FIG 7

## FIG 8

FIG 9

FIG 10A

102 76 104 102 78 M1,M2,M3

98

78

78 76

100

FIG 10B

102 78 CH

98

104

102

78 100 76

FIG 10C

102 78 102 CS

98

104

78 78

100

FIG 11

FIG 12

FIG 13

_72_

70

68

FIG 14

_66_

78

76

84

78

78

76

FIG 15

FIG 16